# EUROPEAN PATENT SPECIFICATION

(11) **EP 3 555 981 B1**
(45) Date of publication and mention of the grant of the patent: **17.02.2021**
(21) Application number: 17829954.1
(22) Date of filing: 15.12.2017
(51) Int. Cl.: H02G 5/00, H02B 1/21, H02B 1/056, H05K 3/46, B32B 15/08

(54) **MULTI-PHASE BUSBAR FOR CONDUCTING ELECTRIC ENERGY AND METHOD OF MANUFACTURING THE SAME**
MEHRPHASIGE SAMMELSCHIENE ZUM LEITEN ELEKTRISCHER ENERGIE UND VERFAHREN ZU IHRER HERSTELLUNG
BARRE OMNIBUS MULTIPHASE POUR LA CONDUCTION D'ÉNERGIE ÉLECTRIQUE ET SON PROCÉDÉ DE FABRICATION

(30) Priority: 19.12.2016 EP 16205013; 19.12.2016 EP 16205020; 19.12.2016 EP 16205023
(43) Date of publication of application: 23.10.2019
(73) Proprietor: ABB Schweiz AG, 5400 Baden (CH)
(72) Inventor: VELTHUIS, Rudi, 79787 Lauchringen (DE); KRIVDA, Andrej, 5430 Wettingen (CH)
(74) Representative: Kesselhut, Wolf
(86) International application number: PCT/EP2017/083056
(87) International publication number: WO 2018/114684

(56) References cited:
- CN-A- 101 252 257
- US-A- 3 396 230
- US-A- 3 400 303
- US-A- 4 358 633
- US-A1- 2008 078 572

## Description

The invention is related to a multi-phase busbar for conducting electric energy and a method of manufacturing the same according to the preamble of claims 1 and 8.

Multi-phase busbars are used in switchboards to conduct and distribute alternating electrical current to different electrical devices which are usually installed in switch gear cabinets. In order to provide for the possibility to conduct all three phases or even more phases of an alternating current in a single busbar, multi-phase busbars have been developed which comprise a base layer and a cover layer of electrically insulating material between which two or more layers of conducting sheet metal, in particular copper, are arranged that are electrically insulated from each other by means of insulating intermediate layers Document CN101252257 discloses a multi-phase busbar for conducting electric energy, comprising a first conducting layer made of a sheet metal which is covered with a first insulating layer, a first conducting pin mounted to said first conducting layer which extends in a direction preferably perpendicular to the first conducting layer, a second conducting layer made of a sheet metal which is covered with a second insulating layer, said first and second insulating layers have a thickness of one millimeter to several millimeters.

An afore-described busbar in which the different layers are laminated to each other by means of liquid resin is described in DE 10 2005 015 945 B4 of the applicant. The laminated busbar has the advantage that it is compact and does not tend to delaminate due to repellant forces which are generated by the alternating electric currents that are conducted in the different conducting layers for each phase and which in case of a short circuit can be in the range of several thousand ampere (kA).

One problem of the busbars as described in DE 10 2005 015 945 B4 are the costs involved in the lamination process itself in which the different layers are bond to each other by means of a liquid resin, like epoxy resin, which is applied to the upper and lower side of each layer and cured afterwards. As the laminating resins used for the laminating process are usually toxic and are said to cause allergic reactions, specific safety precautions for the staff are required in the production process which significantly raise the production costs.

Accordingly, it is an object of the present invention to provide for a multi-phase busbar which can be manufactured at reduced efforts and costs and in a shorter time without the extensive application of a liquid resin to each layer for bonding the layers to each other.

This object is achieved by a multi-phase busbar and a method of manufacturing the same as claimed in claims 1 and 8.

Further objects of the present invention are included in the dependent claims.

The invention has the advantage, that the conducting layers with the insulating coating thereon can be manufactured in separate production steps which may be performed automatically without the necessity that humans might get into contact with liquid resin. The cured coated conducting layers can then be handled as independent units in order to assemble the final busbar. Instead of a lamination of the different layers with liquid resin, the layers may be glued together with an adhesive which can be applied on the bottom or top surface of the dry insulating coating and which may be covered with a protective film, like a foil, which is removed immediately before pressing two or more layers against each other.

Moreover, the invention has the following further advantages:
- Reduced handling steps as no complex mold is required.
- No tight sealing around the conducting pins is needed.
- The casting can be performed without the use of vacuum if an appropriate liquid resin is used.
- The casting and curing process can be significantly expedited by employing a UV-transparent mold and a UV-curable liquid resin.
- In general lower production costs and faster assembly of the busbar compared to currently used systems.

According to the invention, a multi-phase busbar for conducting electric energy, comprises at least a first conducting layer made of a sheet metal which is covered with a first insulating layer, a first conducting pin mounted to said first conducting layer which extends in a direction preferably perpendicular to the first conducting layer, a second conducting layer made of a sheet metal which is covered with a first insulating layer. Said second conducting layer comprises a first pinhole through which said first conducting pin projects and a second conducting pin which extends in a direction parallel to said first conducting pin through said second insulating layer. Each of said conducting layers comprises a first and second connection area at its opposing end portions which serves to electrically connect the respective conducting layer to an electric power supply and/or a connecting area of a further multi-phase busbar.

In a preferred embodiment of the invention, the busbar in total comprises four conducting layers each of which has at least one conducting pin mounted thereat and a layer of an insulating coating applied thereto. However, in this preferred embodiment of the invention, all conducting layers except the lowest one comprise pinholes through which the conducting pins of the lower layers extend.

The multi-phase busbar is characterized in that the first and second insulating layers have a thickness of one millimeter to several millimeters and in particular 1 mm to 5 mm or even more than 5 mm and completely cover the sheet metal outside of the connecting areas, and in that the first and second insulating layers being directly glued on top of or above of each other. For gluing the insulating layers together, a known adhesive may be used, which can be applied to the upper side and/or the lower side of the insulating layer by means of an application roller, e.g. a fur roller or alternatively a double sided scotch tape or by spraying.

In the preferred embodiment of the invention, the second insulating layer comprises a sleeve of insulating material, e.g. reinforced fiber glass or reinforced plastics material which is arranged at least within said first pinhole in said second conducting layer.

The sleeve of insulating material is preferably glued to the insulating material which covers the top and the bottom surface of the second conducting layer or is attached to the insulating material when applying this to the respective conducting layers.

In this embodiment the sleeve may advantageously be made of the same insulating material as the insulating material which is applied to the top and bottom surfaces of the second conducting layer. As applicant has found, the insulating material used is preferably a cured cast resin, e.g. an epoxy resin or a UP resin, which may include additionally reinforcing fibers in order to increase the mechanical strength of the final busbar.

According to another object of the invention, each of said first insulating layer and/or said second insulating layer and also all further insulating layers mounted thereon, comprises at least a first and a second sub layer of an insulating spray coating material or an insulating dip coating material. The spray coating material may be a liquid thermosetting resin or a liquid light-curable resin which is cured by applying heat and/or exposing the resin to UV-light after applying the same to the associated conducting layer, respectively. By using UV-light, the curing times can be significantly reduced and the timing of the curing can be chosen as desired.

In an alternative embodiment of the invention, the first insulating layer and/or the second insulating layer and preferably all other insulating layers may be comprised of at least two sub layers of powder particles each. The particles included in the sub layers are bonded to each other in order to form a continuous insulating layer which completely covers the associated conducting layer except at the connecting areas. The powder may be a mixture of glue and plastic powder or a resin powder which includes sticky partially cured particles which is sprayed onto the surfaces to be coated.

According to another object of the present invention, the first and/or second conducting pins may be covered with a further sleeve which is made of an electrically insulating material and projects away from the sheet metal of said first and/or second conducting layer. The further sleeve which is preferably mounted to each of the conducting pins of a busbar and extends from the surface of the respective conducting layer to a non-insulated contacting area at the opposing end of the pin, to which the electrical devices in a switchboard assembly may be connected, provides for an improved electrical insulation of the busbar. Moreover, due to the adhesive connection of the different insulating layers, the further sleeve eliminates the requirement of filling up the pinholes with liquid resin, in order insulate and bond the layers to each other.

According to yet another object of the present invention, a method of manufacturing a multi-phase busbar 1 as described herein before comprises the following method steps:
Providing a first conducting layer which is made of a sheet metal having a first conducting pin mounted thereto, providing a second conducting layer which is made of a sheet metal having a second conducting pin mounted thereto, forming a first pinhole in said second conducting layer, mounting a protective cover to the opposing end portions of each of said first and second conducting layers to provide for a first and second connection area, mounting a sleeve of an electrically insulating material within said first pinhole, sealing the interior of said sleeve against an entry of insulating coating material, applying an insulating coating material or a spray coating material to the first and second conducting layers and drying said coating material so as to form a continuous insulating layer, aligning said first and second conducting layers with the insulating layers formed thereat relative to each other so that the first conducting pin extends through the first pin hole in the second conducting layer, and gluing the bottom surface of the second insulating layer to the top surface of the first insulating layer. In a multiphase busbar having further conducting layers and further conducting pins and insulating layers mounted thereat, respectively, also the other conducting layers are coated with the insulating material in the afore-described way and, after curing the coating material, are bonded to each other by an adhesive with the conducting pins extending through further pinholes, which are formed in the third and fourth conducting layer, respectively.

According to a preferred embodiment of the invention, the conducting layers are coated with at least two sub layers of coating material in at least two consecutive cycles to form an insulating layer of increased uniform thickness which may not be obtained by applying only one layer of coating material.

As an alternative to applying the insulating layers by spray coating or dip-coating, the insulating coating of the first and/or second conducting layers and also further conducting layers may be applied by a casting process in which the layers are inserted into a mold which is afterward filled up with liquid resin up to a level, which exceeds the upper surface of the conducting layers by the thickness of the coating material of the respective insulating layer. The liquid resin is cured, e.g. by applying heat or UV-light when using a UV-curable resin, and the respective conducting layer is removed from the mold after the resin has been completely cured. The usage of an UV-curable liquid resin provides for the further advantage that the curing time can be significantly reduced.

In this embodiment of the method, it may be advantageous if a sleeve of insulating material is arranged in the pinholes in each of the respective conducting layers, through which the associated conducting pins extend in parallel in the final busbar. In order to avoid the occurrence of resin residues in the pinholes, the interior of the sleeves may be covered with a flexible removable plug-element, e.g. a silicone or rubber plug, before inserting the respective conducting layer into the mold. After the resin in the mold has been completely cured, the plug-element is removed. This embodiment of the invention provides for the advantage, that the coating of the insulating layers is integrally formed with the sleeves and the interior of each sleeve is kept free from resin residues which may prevent an associated conducting pin to be inserted into an associated pinhole.

The invention is hereinafter described with reference to the accompanying drawings. In the drawings
- Fig. 1: is a schematic partial cross sectional view of a 4-phase busbar according to the invetion,
- Fig. 2: is a schematic view of a mold in which a conducting layer with a conducting pin is coated with an insulating coating by resin casting,
- Fig. 3: is a top view of the mold of Fig. 2,
- Fig. 4: is a schematic illustration of a first and a second coated conducting layer before adhesively bonding the layers to each other, and
- Fig. 5: is a partial, cross sectional view of a 4-phase busbar of the invention in the area of a first conducting pin which is additionally electrically insulated by a further sleeve made of an insulating material.

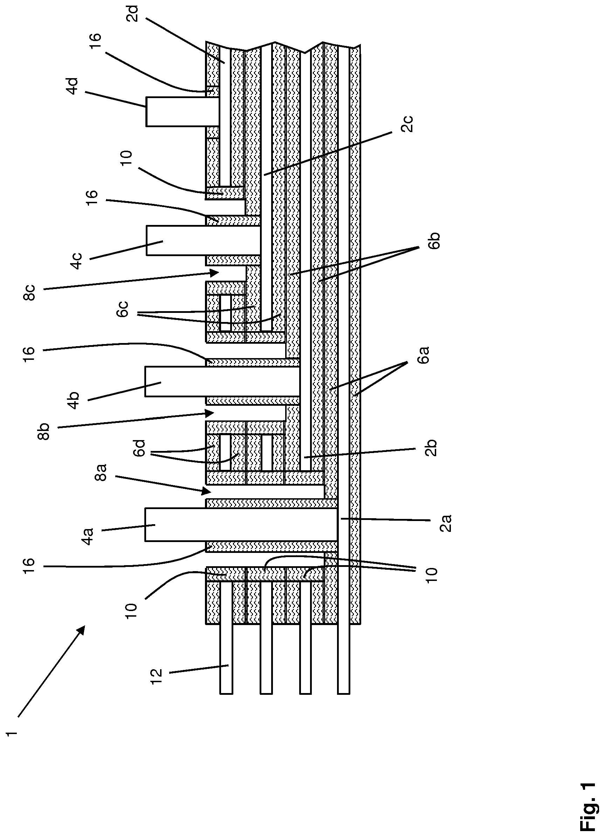

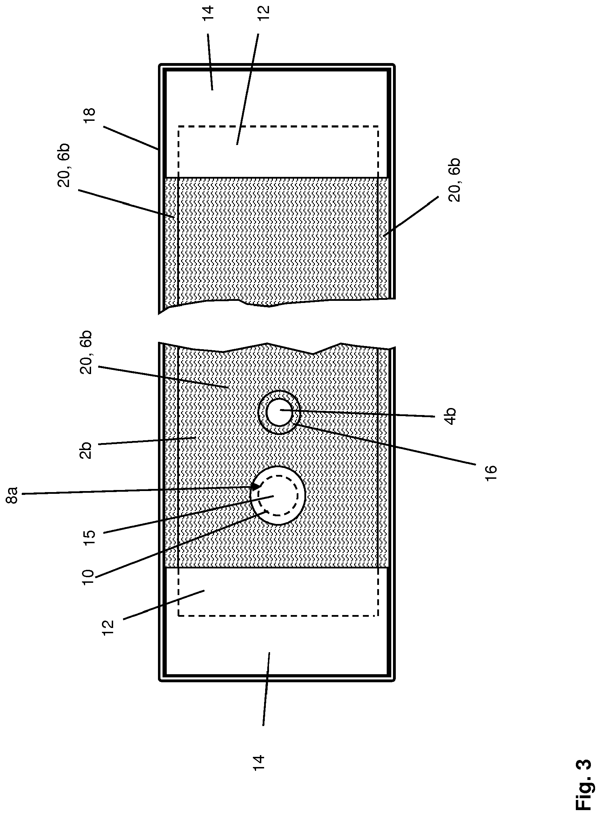

As it is shown in Figs. 1 to 5, a multi-phase busbar 1 for conducting electric energy comprises at least a first conducting layer 2a, which is made of a sheet metal, preferably copper, which can have a thickness of 1 to 5 mm or even more. The first conducting layer 2a comprises at least one first conducting pin 4a which extends in a direction perpendicular to the first conducting layer 2a and which is either integrally formed with the conducting layer 4a when manufacturing the same or which is soldered or mechanically attached to the sheet metal by screwing or clamping.

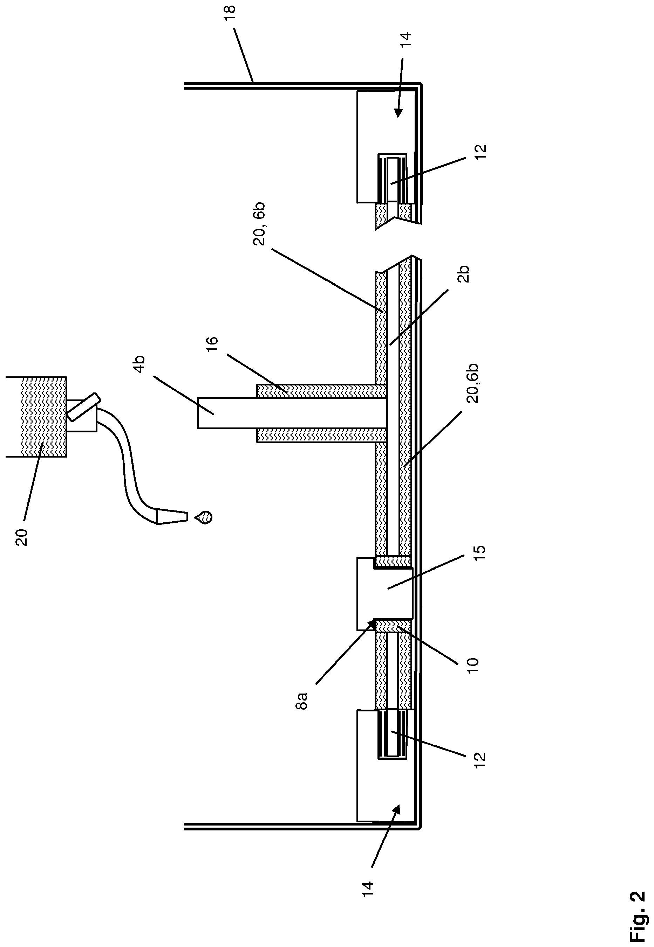

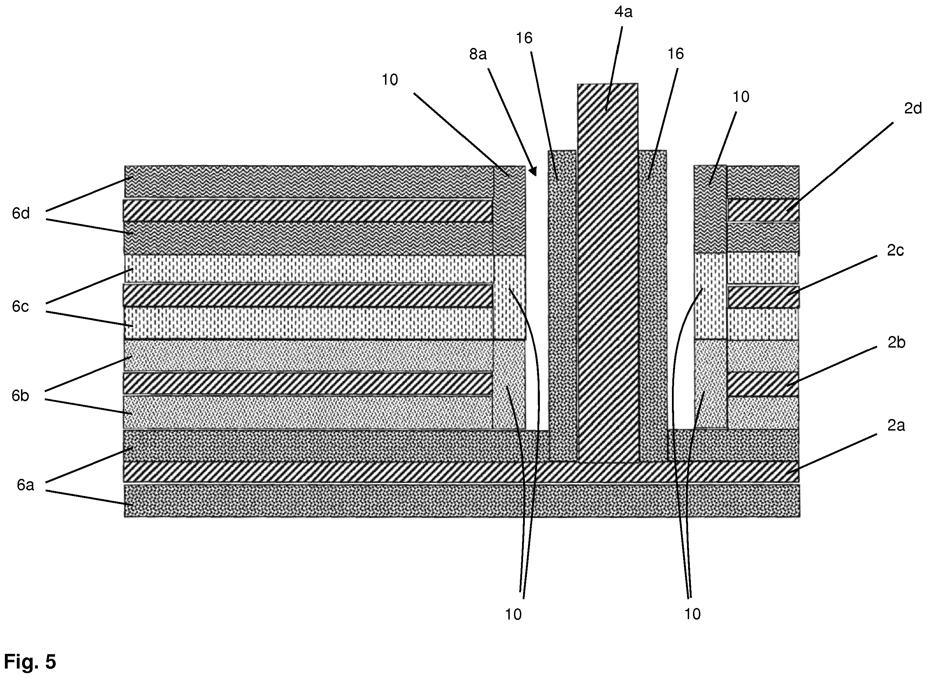

As it can further be seen from Fig. 1 and 5, the busbar 1 comprises a second conducting layer 2b which is preferably made of the same sheet metal as the first conducting layer 2a and which comprises a second conducting pin 4b mounted thereto. In the embodiment shown in Figs. 1 and 2, the first conducting layer 2a forms the base of the busbar 1 which may conduct protective earth potential, whereas the second conducting layer 2b may conduct one of the phases of an alternating current which is fed to the busbar 1 by means of a connection area 12 which is formed at opposing end portions of the conducting layers 2a, 2b.

In case of the shown busbar 1, which is designed for conducting three different phases and protective earth, two further conducting layers 2c, 2d are arranged above the first two conducting layers 2a, 2b.

As it can further be seen from Figs. 1 and 5, the second conducting layer 2b comprises a first pin hole 8a through which the first conducting pin 4a extends in a direction perpendicular to the flat and even sheet material of the first conducting layer 2a. In the same way, a further pin hole 8b and 8c is formed in the third conducting layer 2c and fourth conducting layer 2b, through which an associated conducting pin 4b of the second conducting layer 2b and third conducting pin 4c of the third conducting layer 2c extend. Each of the conducting layers 2a to 2d is covered with an insulating layer 6a to 6d of coating material which completely covers each of the conducting layers 2 except in the connecting areas. The coating material of the insulating layers 6a to 6d has a thickness which preferably is greater than 5 mm, in order to provide for an electrical insulation which withstands a breakdown voltages of several hundred kV. The coating material is preferably a cured liquid resin 20 which may also include reinforcing fibers, in order to provide for a higher mechanical resistance of the busbar 1.

As it is further indicated by the thin double lines between two adjoining insulating layers 6, the insulating layers 6 are glued to each other by means of an adhesive, like the adhesive used in double sided scotch tapes or a known contact adhesive, which can be applied by an applicator roller to the top side and the lower side of the adjoining conducting layers 6, e.g. the layers 6a and 6b and which may be covered by a removable protective film or foil (not shown) that can be pulled off when mounting the layer to a further layer.

In order to provide for a complete covering of the conducting layers 2 with insulating material, a sleeve 10, which has a height that corresponds to the distance between the lower surface area and the upper surface area of an associated insulating layer 6, is inserted in each pinhole or opening 8a to 8c, in order to insulate the annular shaped surface of the respective conducting layer 2 against sparkovers. The sleeve which preferably consists of the same insulating material as the insulating layers 6, is preferably bonded to the material of the insulating layers 6 or integrally formed therewith when applying the coating material to the top surface and bottom surface of the conducting layers 2.

In the same way, sleeves 16 of an insulating material, preferably the same insulating material as the material of the insulating layers 6a to 6d can arranged around the conducting pins 4a to 4c, wherein the upper end of each of the sleeves 16 extends up to the upper surface of the uppermost insulating layer 6d of a busbar 1, independent of how many layers 6 are included therein, as it is shown in Fig. 1.

In order to apply the insulating material of the insulating layers 6 to the outer surfaces of the sheet metal of the conducting layers 2a to 2d, a method may be used which is hereinafter explained with reference to Figs. 2 to 4 on basis of an example in which for the reason of simplicity only two conducting layers 2a, 2b are manufactured and glued to each other.

In order to coat the conducting layers 2, the connecting areas 12 on each of the opposing sides of the conducting layer 2 are covered by means of a protective cover 14, which may be a block shaped rubber element or silicon element in which a pocket is formed that receives the end portion of the conducting layer 2 in a sealing manner. In the same way, a sleeve 10 of a cured insulating material, e.g. a cured reinforced fiber material, having a height which spans the distance between the bottom surface and the top surface of the coating of the associated insulating layer 6 is inserted into the pin hole or opening 8 in the associated conducting layer 2 and the interior of the sleeve 10 is covered by a flexible removable plug element 15.

In a next step, a conducting layer 2 with the protective covers 14 mounted thereon and the sleeve 10 with the plug element 15 inserted therein are inserted into a mold 18, as it is exemplary shown with regard to the second conducting layer 2b. Optionally, a further sleeve 16 which is made of the same insulating material as the insulating layers 6 and/or the sleeve 10 may be mounted on the conducting pin 4b.

Next, liquid curable resin 20 is filled into the mold 18 until the upper level of the resin 20 matches the desired thickness of the insulating layer 6b on top of the second conducting layer 2b, e.g. which may be a thickness of 5 mm or more on each side of the conducting layer 2.

When the desired level of liquid resin 20 has been reached, the resin is cured, e.g. by applying heat and/or pressure and/or UV-light to the upper and lower side of the mold which may therefore be made of a material which is transparent for UV-light.

After curing the resin, which in the cured state forms the insulting material of the insulating layers 6a to 6d that covers the conducting layers 2a to 2d, the cured arrangement is taken out of the mold 18 as a unit and the protective covers 14 and the plug element 15 are removed.

In a similar way, at least the first conducting layer 2a which represents the base in the stack of layers of the final busbar 1 is coated with liquid resin 20 with the difference, that no plug 15 has to be employed, as the first conducting layer 2a does not comprise a pin hole 8. However, in case of a busbar 1 which includes a third and a fourth conducting layer 2c, 2d, as e.g. the busbar shown in Fig. 1 and Fig. 5, additional flexible plug elements 15 and sleeves 10 may be used in each of the pin holes 8a to 8c to provide for an entire continuous insulation of the conducting layers 2 around the pin holes 8.

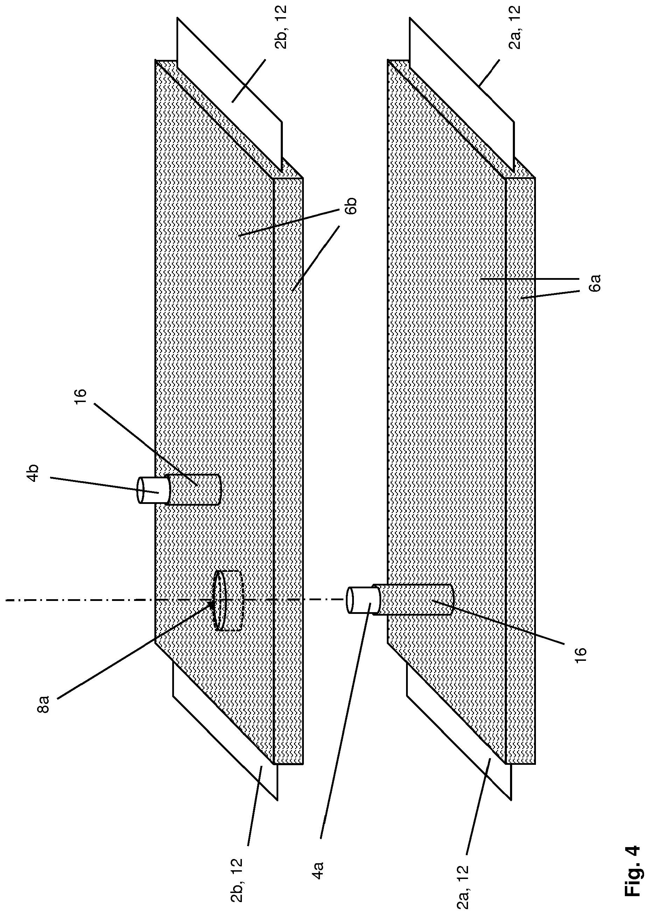

After all coated conducting layers 2a to 2d of a busbar 1 have been manufactured in the way as described herein before, the layers are aligned to each other as it is exemplarily shown for layers 2a and 2b in Fig. 4, before finally bonding the two layers together by means of an adhesive as mentioned before.

### Listing of reference numerals

- 1: busbar
- 2a: first conducting layer
- 2b: second conducting layer
- 2c: third conducting layer
- 2d: fourth conducting layer
- 4a: first conducting pin
- 4b: second conducting pin
- 4c: third conducting pin
- 4d: fourth conducting pin
- 6a: first intermediate layer
- 6b: second intermediate layer
- 6c: third intermediate layer
- 6d: fourth intermediate layer
- 8a: first pinhole
- 8b: second pinhole
- 8c: third pinhole
- 10: sleeve of insulating material
- 12: connection area
- 14: protective cover
- 15: flexible plug element
- 16: further sleeve
- 18: mold
- 20: liquid resin

## Claims

1. Multi-phase busbar (1) for conducting electric energy, comprising a first conducting layer (2a) made of a sheet metal which is covered with a first insulating layer (6a), a first conducting pin (4a) mounted to said first conducting layer (2a) which extends in a direction preferably perpendicular to the first conducting layer (2a), a second conducting layer (2b) made of a sheet metal which is covered with a second insulating layer (6b), said second conducting layer (2b) comprising a first pinhole (8a) through which said first conducting pin (4a) projects and a second conducting pin (4b) which extends in a direction parallel to said first conducting pin (4a) through said second insulating layer (6b), wherein each of said conducting layers (2a, 2b) comprises a first and second connection area (12) at its opposing end portions for electrically connecting said conducting layer (2a, 2b) to an electric power supply and/or a connecting area (12) of a further multi-phase busbar (1),
whereby said first and second insulating layers (6a, 6b) have a thickness of one millimeter to several millimeters, in particular 1 mm to 5 mm or more than 5 mm, and completely cover said sheet metal outside of said connecting areas (12), and that said first and second insulating layers (6a, 6b) are directly glued on top of each other.

2. Multi-phase busbar according to claim 1, **characterized in that** said second insulating layer (6b) comprises a sleeve (10) of insulating material which is arranged within said first pinhole (8a) in said second conducting layer (2b), said sleeve (10) of insulating material being bonded to the insulating material covering a top and a bottom surface of said second conducting layer (2b).

3. Multi-phase busbar according to claim 2, **characterized in that** said sleeve (10) is made of the same insulating material as the insulating material covering said top and bottom surface of said second conducting layer (2b).

4. Multi-phase busbar according to any of the preceding claims,
**characterized in that** said insulating material covering the first and/or second conducting layer (2a, 2b) is a cured cast resin (20).

5. Multi-phase busbar according to claim 1,
**characterized in that** said first insulating layer (6a) and/or said second insulating layer (6b) each comprises at least a first and a second sub layer of an insulating spray coating material or an insulating dip coating material, preferably a cured thermosetting resin (20) or a cured light-curable resin (20).

6. Multi-phase busbar according to claim 5,
**characterized in that** said first insulating layer (6a) and/or said second insulating layer (6b) are each comprised of at least two sub layers of powder particles, preferably plastic powder particles or resin powder particles, said particles being bonded to each other to form a continuous insulating layer (6a, 6b).

7. Multi-phase busbar according to any of the preceding claims,
**characterized in that** said first and/or second conducting pins (4a, 4b) are covered by a further sleeve (16) which is made of an electrically insulating material and projects away from the sheet metal of said first and/or second conducting layer (2a, 2b).

8. Method of manufacturing a multi-phase busbar according to claim 1, comprising the following method steps:
- providing a first conducting layer (2a) made of a sheet metal having a first conducting pin (4a) mounted thereto,
- providing a second conducting layer (2b) made of a sheet metal having a second conducting pin (4b) mounted thereto,
- forming a first pinhole (8a) in said second conducting layer (2b),
- mounting a protective cover (14) to the opposing end portions of each of said first and second conducting layers (2a, 2b) to provide for a first and second connection area (12),
- mounting a sleeve (10) of an electrically insulating material within said first pinhole (8a),
- sealing the interior of said sleeve (10) against an entry of insulating coating material (20),
- applying an insulating coating material or a spray coating material (20) to the first and second conducting layer (2a, 2b) and drying said coating material (20) so as to form a continuous insulating layer (6a, 6b),
- aligning said first and second conducting layers (2a, 2b) relative to each other so that the first conducting pin (6a) extends through the first pin hole (8a) in the second conducting layer, and
- gluing the bottom surface of said second insulating layer (6b) to the top surface of said first insulating layer (6a).

9. Method of claim 8,
**characterized in that** the coating material is applied to said first and/or second conducting layer (2a, 2b) in at least two consecutive cycles to form an insulating layer (6a, 6b) of increased thickness.

10. Method of claim 8,
**wherein** for forming said insulating coating on said first and/or second conducting layers (2a, 2b), said first and/or the second conducting layer (2a, 2b) is inserted into a mold (18), said mold (18) is filled up with liquid resin (20), said liquid resin (20) is cured and said first and/or second conducting layer (2a, 2b) is removed from said mold (18).

11. Method of claim 10,
**wherein** said sleeve (10) is arranged in said first pinhole (8a) and said interior of said sleeve (10) is covered with a flexible removable plug-element (15) before inserting the second conducting layer (2b) in said mold (18), said plug-element (15) being removed from said sleeve (10) after curing said resin (20).

## Patentansprüche

1. Mehrphasige Sammelschiene (1) zum Leiten von elektrischer Energie, die Folgendes umfasst: eine erste leitende Schicht (2a), die aus einem Metallblech hergestellt ist, das mit einer ersten isolierenden Schicht (6a) bedeckt ist, einen ersten leitenden Stift (4a), der an der ersten leitenden Schicht (2a) montiert ist, der sich in einer Richtung erstreckt, die bevorzugt senkrecht zu der ersten leitenden Schicht ist (2a), eine zweite leitende Schicht (2b), die aus einem Metallblech hergestellt ist, das mit einer zweiten isolierenden Schicht (6b) bedeckt ist, wobei die zweite leitende Schicht (2b) ein erstes Stiftloch (8a), durch das der erste leitende Stift (4a) vorragt, und einen zweiten leitenden Stift (4b) umfasst, der sich in einer Richtung parallel zu dem ersten leitenden Stift (4a) durch die zweite isolierende Schicht (6b) erstreckt, wobei jede der leitenden Schichten (2a, 2b) an ihren gegenüberliegenden Endabschnitten einen ersten und zweiten Verbindungsbereich (12) zum elektrischen Verbinden der leitenden Schicht (2a, 2b) mit einer elektrischen Leistungsversorgung und/oder einem Verbindungsbereich (12) einer weiteren mehrphasigen Sammelschiene (1) umfasst,
wobei die erste und die zweite isolierende Schicht (6a, 6b) eine Dicke von einem Millimeter bis zu mehreren Millimetern, insbesondere 1 mm bis 5 mm oder mehr als 5 mm, aufweisen, und das Metallblech außerhalb der Verbindungsbereiche (12) vollständig bedecken, und die erste und zweite isolierende Schicht (6a, 6b) direkt aufeinander geklebt sind.

2. Mehrphasige Sammelschiene nach Anspruch 1, **dadurch gekennzeichnet, dass** die zweite leitende Schicht (6b) eine Manschette (10) aus isolierendem Material umfasst, die in dem ersten Stiftloch (8a) in der zweiten leitenden Schicht (2b) angeordnet ist, wobei die Manschette (10) aus isolierendem Material an das isolierende Material gebondet ist, das eine Ober- und eine Unterseite der zweiten leitenden Schicht (2b) bedeckt.

3. Mehrphasige Sammelschiene nach Anspruch 2, **dadurch gekennzeichnet, dass** die Manschette (10) aus demselben isolierenden Material hergestellt ist, wie das isolierende Material, das die Ober- und Unterseite der zweiten leitenden Schicht (2b) bedeckt.

4. Mehrphasige Sammelschiene nach einem der vorhergehenden Ansprüche, **dadurch gekennzeichnet, dass** das isolierende Material, das die erste und/oder zweite leitende Schicht (2a, 2b) bedeckt, ein ausgehärtetes Gießharz (20) ist.

5. Mehrphasige Sammelschiene nach Anspruch 1, **dadurch gekennzeichnet, dass** die erste isolierende Schicht (6a) und/oder die zweite isolierende Schicht (6b) jeweils zumindest eine erste und eine zweite Unterschicht aus einem isolierenden Sprühbeschichtungsmaterial oder einem isolierenden Tauchbeschichtungsmaterial, bevorzugt einem ausgehärteten wärmehärtbaren Harz (20) oder einem ausgehärteten lichthärtbaren Harz (20) umfassen.

6. Mehrphasige Sammelschiene nach Anspruch 5, **dadurch gekennzeichnet, dass** die erste isolierende Schicht (6a) und/oder die zweite isolierende Schicht (6b) jeweils aus mindestens zwei Unterschichten aus Pulverpartikeln bestehen, bevorzugt Plastikpulverpartikel oder Harzpulverpartikel, wobei die Partikel aneinander gebondet sind, um eine kontinuierliche isolierende Schicht (6a, 6b) zu bilden.

7. Mehrphasige Sammelschiene nach einem der vorhergehenden Ansprüche, **dadurch gekennzeichnet, dass** der erste und/oder zweite leitende Stift (4a, 4b) durch eine weitere Manschette (16) bedeckt sind, die aus einem elektrisch isolierenden Material hergestellt ist und von dem Metallblech der ersten und/oder zweiten leitenden Schicht (2a, 2b) weg vorragt.

8. Verfahren zum Herstellen einer mehrphasigen Sammelschiene nach Anspruch 1, das die folgenden Verfahrensschritte umfasst:
- Bereitstellen einer ersten leitenden Schicht (2a), die aus einem Metallblech hergestellt ist, das einen ersten leitenden Stift (4a) aufweist, der darauf montiert ist,
- Bereitstellen einer zweiten leitenden Schicht (2b), die aus einem Metallblech hergestellt ist, das einen zweiten leitenden Stift (4b) aufweist, der darauf montiert ist,
- Bilden eines ersten Stiftlochs (8a) in der zweiten leitenden Schicht (2b),
- Montieren einer Schutzabdeckung (14) auf den gegenüberliegenden Endabschnitten der ersten und zweiten leitenden Schicht (2a, 2b), um einen ersten und zweiten Verbindungsbereich (12) bereitzustellen,
- Montieren einer Manschette (10) aus einem elektrisch isolierenden Material in dem ersten Stiftloch (8a),
- Abdichten der Innenseite der Manschette (10) gegen einen Eintritt eines isolierenden Beschichtungsmaterials (20),
- Aufbringen eines isolierenden Beschichtungsmaterials oder eines Sprühbeschichtungsmaterials (20) auf die erste und zweite leitende Schicht (2a, 2b) und Trocknen des Beschichtungsmaterials (20), um eine kontinuierliche isolierende Schicht (6a, 6b) zu bilden,
- Ausrichten der ersten und zweiten leitenden Schicht (2a, 2b) relativ zueinander, so dass sich der erste leitende Stift (6a) durch das erste Stiftloch (8a) in die zweite leitende Schicht erstreckt, und
- Kleben der Unterseite der zweiten isolierenden Schicht (6b) an die Oberseite der ersten isolierenden Schicht (6a).

9. Verfahren nach Anspruch 8, **dadurch gekennzeichnet, dass** das Beschichtungsmaterial in mindestens zwei aufeinanderfolgenden Zyklen auf die erste und/oder zweite leitende Schicht (2a, 2b) aufgebracht wird, um eine isolierende Schicht (6a, 6b) mit erhöhter Dicke zu bilden.

10. Verfahren nach Anspruch 8, wobei zum Bilden der isolierenden Beschichtung auf der ersten und/oder zweiten leitenden Schicht (2a, 2b) die erste und/oder die zweite leitende Schicht (2a, 2b) in eine Form (18) eingesetzt werden, die Form (18) mit flüssigem Harz (20) aufgefüllt wird, das flüssige Harz (20) ausgehärtet wird und die erste und/oder zweite leitende Schicht (2a, 2b) aus der Form (18) entfernt werden.

11. Verfahren nach Anspruch 10, wobei die Manschette (10) in dem ersten Stiftloch (8a) angeordnet wird und die Innenseite der Manschette (10) vor dem Einsetzen der zweiten leitenden Schicht (2b) in die Form (18) mit einem flexiblen, lösbaren Steckelement (15) bedeckt wird, wobei das Steckelement (15) nach dem Aushärten des Harzes (20) von der Manschette (10) entfernt wird.

## Revendications

1. Barre omnibus multiphase (1) destinée à conduire une énergie électrique, comprenant une première couche conductrice (2a) constituée d'un métal en feuille qui est recouverte d'une première couche isolante (6a), une première broche conductrice (4a) montée sur ladite première couche conductrice (2a) qui s'étend dans une direction de préférence perpendiculaire à la première couche conductrice (2a), une seconde couche conductrice (2b) constituée d'un métal en feuille qui est recouverte d'une seconde couche isolante (6b), ladite seconde couche conductrice (2b) comprenant un premier trou d'aiguille (8a) à travers lequel ladite première broche conductrice (4a) fait saillie et une seconde broche conductrice (4b) qui s'étend dans une direction parallèle à ladite première broche conductrice (4a) à travers ladite seconde couche isolante (6b), chaque couches desdites couches conductrices (2a, 2b) comprenant une première et une seconde zone de connexion (12) au niveau de ses parties d'extrémités opposées pour connecter électriquement ladite couche conductrice (2a, 2b) à une alimentation électrique et/ou une zone de connexion (12) d'une autre barre omnibus multiphase (1),
moyennant quoi lesdites première et seconde couches isolantes (6a, 6b) ont une épaisseur d'un à plusieurs millimètres, en particulier de 1mm à 5 mm ou plus de 5 mm, et recouvrent complètement ledit métal en feuille en dehors desdites zones de connexion (12), et lesdites première et seconde couches isolantes (6a, 6b) sont collées directement l'une au-dessus de l'autre.

2. Barre omnibus multiphase selon la revendication 1, **caractérisée en ce que** ladite seconde couche isolante (6b) comprend un manchon (10) de matériau isolant qui est disposé à l'intérieur dudit premier trou d'aiguille (8a) dans ladite seconde couche conductrice (2b), ledit manchon (10) de matériau isolant étant collé au matériau isolant recouvrant une surface supérieure et une surface inférieure de ladite seconde couche conductrice (2b).

3. Barre omnibus multiphase selon la revendication 2, **caractérisée en ce que** ledit manchon (10) est constitué du même matériau isolant que le matériau isolant recouvrant lesdites surfaces supérieure et inférieure de ladite seconde couche conductrice (2b).

4. Barre omnibus multiphase selon l'une quelconque des revendications précédentes, **caractérisée en ce que** ledit matériau isolant recouvrant les première et/ou seconde couches conductrices (2a, 2b) est une résine de coulée durcie (20).

5. Barre omnibus multiphase selon la revendication 1, **caractérisée en ce que** ladite première couche isolante (6a) et/ou ladite seconde couche isolante (6b) comprennent chacune au moins une première et une seconde sous-couche d'un matériau de revêtement par pulvérisation isolant ou d'un matériau de revêtement au trempé isolant, de préférence une résine thermodurcissable durcie (20) ou une résine durcissable à la lumière durcie (20).

6. Barre omnibus multiphase selon la revendication 5, **caractérisée en ce que** ladite première couche isolante (6a) et/ou ladite seconde couche isolante (6b) sont chacune composée d'au moins deux sous-couches de particules pulvérulentes, de préférence des particules pulvérulentes de résine, lesdites particules étant agglomérées les unes aux autres pour former une couche isolante continue (6a, 6b).

7. Barre omnibus multiphase selon l'une quelconque des revendications précédentes, **caractérisée en ce que** lesdites première et/ou seconde broches conductrices (4a, 4b) sont recouvertes d'un autre manchon (16) constitué d'un matériau électriquement isolant qui fait saillie vers l'extérieur du métal en feuille desdites première et/ou seconde couches conductrices (2a, 2b).

8. Procédé de fabrication d'une barre omnibus multiphase selon la revendication 1, comprenant les étapes de procédé suivantes :
la fourniture d'une première couche conductrice (2a) constituée d'un métal en feuille sur laquelle est montée une première broche conductrice (4a) ,
- la fourniture d'une seconde couche conductrice (2b) constituée d'un métal en feuille sur laquelle est montée une seconde broche conductrice (4b),
- la formation d'un premier trou d'aiguille (8a) dans ladite seconde couche conductrice (2b),
- le montage d'un couvercle de protection (14) sur les parties d'extrémité opposées de chacune desdites première et seconde couches conductrices (2a, 2b) pour fournir des première et seconde zones de connexion (12),
le montage d'un manchon (10) d'un matériau électriquement isolant à l'intérieur dudit premier trou d'aiguille (8a),
le scellement de l'intérieur dudit manchon (10) contre une entrée de matériau de revêtement isolant (20),
l'application d'un matériau de revêtement isolant ou d'un matériau de revêtement par pulvérisation (20) sur les première et seconde couches conductrices (2a, 2b) et le séchage dudit matériau de revêtement (20) de manière à former une couche isolante continue (6a, 6b),
l'alignement desdites première et seconde couches conductrices (2a, 2b) l'une avec l'autre de telle sorte que la première broche conductrice (6a) s'étende à travers le premier trou d'aiguille (8a) dans la seconde couche conductrice, et
- le collage de la surface inférieure de ladite seconde couche isolante (6b) sur la surface supérieure de ladite première couche isolante (6a).

9. Procédé selon la revendication 8, **caractérisé en ce que** le matériau de revêtement est appliqué sur lesdites première et/ou seconde couches conductrices (2a, 2b) dans au moins deux cycles consécutifs pour former une couche isolante (6a, 6b) de plus grande épaisseur.

10. Procédé selon la revendication 8, dans lequel pour former ledit revêtement isolant sur lesdites première et/ou seconde couches conductrices (2a, 2b), lesdites première et/ou seconde couches conductrices (2a, 2b) sont insérées à l'intérieur d'un moule (18), ledit moule (18) est rempli de résine liquide (20), ladite résine liquide (20) est durcie et lesdites première et/ou seconde couches conductrices (2a, 2b) sont retirées dudit moule (18).

11. Procédé selon la revendication 10, dans lequel ledit manchon (10) est disposé dans le petit premier trou d'aiguille (8a) et ledit intérieur dudit manchon (10) est recouvert d'un élément de fiche amovible souple (15) avant l'insertion de la seconde couche conductrice (2b) dans ledit moule (18), ledit élément de fiche (15) étant retiré dudit manchon (10) après le durcissement de ladite résine (20).
